Europäisches Patentamt

European Patent Office

Office européen des brevets

(19)

(11) Veröffentlichungsnummer: **0 124 829**

A1

(12) ## EUROPÄISCHE PATENTANMELDUNG

(21) Anmeldenummer: 84104685.7

(51) Int. Cl.³: **C 23 C 13/12**

(22) Anmeldetag: 26.04.84

(30) Priorität: 06.05.83 DE 3316554

(43) Veröffentlichungstag der Anmeldung:
14.11.84 Patentblatt 84/46

(84) Benannte Vertragsstaaten:
AT CH DE FR GB IT LI NL SE

(71) Anmelder: Dr. Johannes Heidenhain GmbH
Nansenstrasse 17
D-8225 Traunreut(DE)

(72) Erfinder: Flatscher, Georg, Dr. Dipl.-Phys.
Waldeck 7
D-8230 Schneizlreuth(DE)

(72) Erfinder: Beckerbauer, Anton
Biebinger Strasse 10
D-8221 Nussdorf(DE)

(54) **Verdampfervorrichtung mit Strahlheizung zum Aufdampfen mehrerer Materialien.**

(57) Bei einer derartigen Verdampfereinrichtung mit einer Elektronenstrahlheizung (EH) sind zur Aufdampfung mehrerer Materialien (M) auf ein Substrat (S) in einer Vakuumkammer wenigstens zwei Tiegel (T) zur Aufnahme je eines Verdampfungsmaterials (M) konzentrisch in einem Drehtisch (R) angeordnet. Zur gleichmäßigeren Verdampfung der Materialien (M) ist wenigstens der dem Elektronenstrahl (E) jeweils zugeordnete Tiegel (T) im Drehtisch (R) drehbar gelagert.

Fig. 1

EP 0 124 829 A1

DR. JOHANNES HEIDENHAIN GMBH

9. Februar 1984


Verdampfervorrichtung mit Strahlheizung zum
Aufdampfen mehrerer Materialien
===================================================


Die Erfindung betrifft eine Verdampfervorrichtung
mit Strahlheizung zum Aufdampfen mehrerer Materialien gemäß dem Oberbegriff des Anspruchs.


Aus der US-PS 2 482 329 ist eine Verdampfereinrichtung bekannt, bei der zur Verdampfung mehrerer
Verdampfungsmaterialien diese in konzentrisch zueinander angeordneten Ausnehmungen auf einer drehbaren Kreisscheibe aufgenommen sind. Die Kreisscheibe ist schrittweise zur Zuordnung jeweils
einer Ausnehmung zu einer Heizquelle drehbar.


Der GB-PS 1 318 046 entnimmt man eine Verdampfervorrichtung, die einen Drehtisch mit konzentrischen
Nuten zur Aufnahme von Verdampfungsmaterialien aufweist. Durch eine Elektronenstrahlquelle wird das
Verdampfungsmaterial in eng begrenzten Bereichen,
die quasi als Tiegel aufgefaßt werden können, auf
Verdampfungstemperatur erhitzt.


Die DE-OS 30 10 925 betrifft eine Verdampfervorrichtung, die einen Drehtisch mit konzentrisch
angeordneten, eingefrästen Tiegeln zur Aufnahme
mehrerer Verdampfungsmaterialien aufweist, die
einer Elektronenstrahlquelle sukzessive zur Verdampfung zugeordnet werden.


In der DE-OS 26 50 215 wird vorgeschlagen, zur
gleichmäßigeren Verdampfung das zu verdampfende
Material drehbar zu lagern.

Der Erfindung liegt die Aufgabe zugrunde, eine
Verdampfervorrichtung der oben genannten Gattung
anzugeben, mit der verschiedene Verdampfungsmate-rialien in reproduzierbarer Schichtdicke auf wenigstens einem Substrat aufgebracht werden können.

Diese Aufgabe wird erfindungsgemäß durch die kennzeichnenden Merkmale des Anspruchs gelöst.

Die mit der Erfindung erzielten Vorteile bestehen insbesondere darin, daß mit nur einer Strahlheizung verschiedene Materialien auf wenigstens einem Substrat ohne Zwischenbelüftung der Vakuumkammer aufgebracht werden können, so daß sich eine erhebliche Zeit- und Kostensenkung sowie eine wesentliche Reduzierung der Ausschußrate durch das Ausbilden reproduzierbarer Schichtdicken auf dem Substrat und durch die Vermeidung des Eindringens von Fremdatomen während der Zwischenbelüftung in die Vakuumkammer ergeben.

Ein Ausführungsbeispiel wird anhand der Zeichnung näher erläutert.

Es zeigen

Figur 1    eine Verdampfereinrichtung mit einer Vakuumkammer im Querschnitt und

Figur 2    eine Draufsicht auf einen Drehtisch.

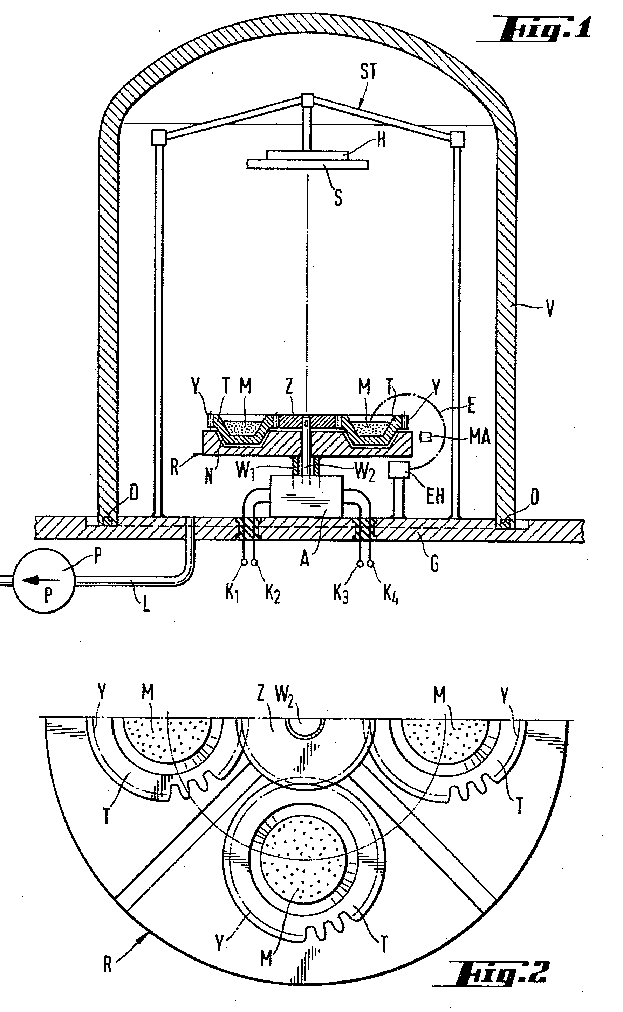

In Figur 1 ist eine Verdampfereinrichtung mit einer Vakuumkammer im Querschnitt gezeigt, bei der auf einer Grundplatte G eine Vakuumhaube V mittels einer Dichtung D vakuumdicht angeordnet ist. Die

- 3 -

Vakuumkammer ist über eine Saugleitung L mit einer Vakuumpumpe P verbunden. Innerhalb der Vakuumkammer ist an einem Ständer ST ein Halter H aufgehängt, an dessen Unterseite ein Substrat S gehalten ist, dessen Unterseite nacheinander mit mehreren Materialien M bedampft werden soll.

Auf der Grundplatte G ist ferner innerhalb der Vakuumkammer mittig eine Antriebseinheit A mit einer äußeren senkrechten Hohlwelle $W_1$ vorgesehen, die einen Drehtisch R mit vier konzentrisch angeordneten Tiegeln T zur Aufnahme von verschiedenen Bedampfungsmaterialien M trägt. Unterhalb des Drehtisches R ist an seiner Peripherie eine Elektronenstrahlheizung EH auf der Grundplatte G angeordnet, deren Elektronenstrahl E auf einer gekrümmten Bahn mittels einer magnetischen Ablenkvorrichtung MA auf die Oberfläche eines zu verdampfenden Materials M in einem Tiegel T auftrifft.

Die vier Tiegel T sind in Ausnehmungen N des Drehtisches R drehbar gelagert und werden von einer in der äußeren Hohlwelle $W_1$ drehbaren inneren Welle $W_2$ mittels eines Zahnrades Z angetrieben, das in Höhe der drehbaren Tiegel T über dem Drehtisch R in jeweils eine Außenverzahnung Y der Tiegel T eingreift (Figur 2). Während des Verdampfungsvorgangs rotieren die Tiegel T mit einer wählbaren konstanten Winkelgeschwindigkeit, so daß das Verdampfungsmaterial M des dem Elektronenstrahl E jeweils zugeordneten Tiegels T gleichmäßiger verdampft wird, wodurch reproduzierbare Schichtdicken auf dem Substrat S aufgebracht und die Ausschußrate erheblich gesenkt werden können; durch diese gleichmäßige Verdampfung

- 4 -

kann auch ein erheblich größerer Teil des Verdampfungsmaterials M aus einem Tiegel T verdampft werden, da die bei einem stationären Tiegel häufig auftretende Kraterbildung in der Oberfläche des Verdampfungsmaterials weitgehend vermieden wird.

Zur Verdampfung der weiteren Verdampfungsmaterialien M in den anderen Tiegeln T werden die betreffenden Tiegel T durch Drehen des Drehtisches R nacheinander jeweils dem Elektronenstrahl E zugeordnet, so daß das Aufbringen verschiedener Materialien M auf das Substrat S ohne Zwischenbelüftung der Vakuumkammer nacheinander ermöglicht wird. Die Steuerung der Antriebseinheit A zur Zuordnung eines bestimmten Tiegels T zum Elektronenstrahl E erfolgt durch elektrische Leitungen $K_1$, $K_2$ und die Stromversorgung für die Eigenrotation der Tiegel T durch elektrische Leitungen $K_3$, $K_4$; die elektrischen Leitungen $K_1$ - $K_4$ sind vakuumdicht durch die Grundplatte G herausgeführt. In nicht gezeigter Weise kann auch nur der dem Elektronenstrahl zugeordnete Tiegel drehbar sein.

0124829

DR. JOHANNES HEIDENHAIN GMBH

9. Februar 1984

Anspruch
========

Verdampfervorrichtung mit Strahlheizung zum Aufdampfen mehrerer Materialien auf wenigstens ein
Substrat, die wenigstens zwei Tiegel zur Aufnahme
je eines Verdampfungsmaterials in konzentrischer
Anordnung auf einem Drehtisch aufweist, dadurch
gekennzeichnet, daß zumindest der dem Heizstrahl (E)
jeweils zugeordnete Tiegel (T) im Drehtisch (R)
drehbar angeordnet ist.

0124829

**Fig.1**

**Fig.2**

**EUROPÄISCHER RECHERCHENBERICHT**

### EINSCHLÄGIGE DOKUMENTE

EP 84104685.7

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| D,X | DE - A1 - 3 010 925 (G.A. FISCHER) <br> * Ansprüche; Abbildung 2 * <br> -- | 1 | C 23 C 13/12 |
| X | CH - A - 553 258 (AGA AKTIEBOLAG) <br> * Ansprüche; Fig. * <br> ---- | 1 | |

**RECHERCHIERTE SACHGEBIETE (Int. Cl. ³)**

C 23 C

Der vorliegende Recherchenbericht wurde für alle Patentansprüche erstellt.

| Recherchenort | Abschlußdatum der Recherche | Prüfer |
|---|---|---|
| WIEN | 29-06-1984 | SLAMA |

EPA Form 1503 03.82

KATEGORIE DER GENANNTEN DOKUMENTEN
X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder
   nach dem Anmeldedatum veröffentlicht worden ist
D : in der Anmeldung angeführtes Dokument
L : aus andern Gründen angeführtes Dokument

 

& : Mitglied der gleichen Patentfamilie, übereinstimmendes Dokument